# EUROPEAN PATENT SPECIFICATION

(11) **EP 2 175 457 B1**
(45) Date of publication and mention of the grant of the patent: **18.04.2012**
(21) Application number: 09012025.4
(22) Date of filing: 22.09.2009
(51) Int. Cl.: H01C 1/148, H01C 1/028, H01L 41/08, H01L 41/24

(54) **Ceramic chip assembly**
Keramik-Chip-Anordnung
Ensemble de puce en céramique

(30) Priority: 09.10.2008 KR 20080099110; 02.07.2009 KR 20090060215
(43) Date of publication of application: 14.04.2010
(73) Proprietor: Joinset Co., Ltd, 425-866-Kyeonggi-do (KR)
(72) Inventor: Kim, Sun-ki, Gunpo-si Kyeonggi-do 435-040 (KR); Lee, Suk-Joo, Sangnok-gu Ansan-si Kyeonggi-do 426-829 (KR)
(74) Representative: Kuhnen & Wacker

(56) References cited:
- JP-A- 2006 060 027
- JP-A- 2008 026 200
- US-A- 4 155 532
- US-A- 4 341 013
- US-A- 4 785 990
- US-A1- 2003 038 160

## Description

### BACKGROUND ART

### Field of the Invention

The present invention relates to a ceramic chip assembly, and more particularly, to a ceramic chip assembly having a thin thickness and improved mechanical strength, which includes an insulating protection layer having a uniform thickness. Also, the present invention relates to a ceramic chip assembly, an internal ceramic chip of which is protected from external loads, shocks and frictions, and nearly not influenced by external environment. Furthermore, the present invention relates to a ceramic chip assembly having high productive and economical efficiency because its material cost is cheap and continuous job is possible in reel taping manner.

### Description of the Related Art

US 4 341 013 A discloses a method of manufacturing a ceramic chip assembly comprising a taped-shaped transport carrier is continuously provided with power supply leads having a U-shaped portion projecting over the edge of the transport carrier, the U-shaped portion is bent up to form a loop and is then provided with bends, the U-shaped connection part is bent down approximately 90° so that the front bends from an insertion aid for the insertion of the components between the supply leads.
JP 2008 026200 A discloses a ceramic chip assembly including a ceramic base, a plurality of external electrodes, a pair of metal lead wires, and an insulating protection material.
As a method of mounting a ceramic chip having electrical characteristics of semiconductors such as thermistors, magnetic substances, and piezoelectrics onto a printed circuit board (PCB), there is a method of electrically and mechanically connecting the ceramic chip and the printed circuit board by soldering a lead wire and a lead frame on a conductive pattern of the printed circuit board after making a ceramic chip assembly by soldering a metal lead wire or a lead frame on the ceramic chip. In this case, because ceramic chips having the electrical characteristics of semiconductors have so weak mechanical strength that they may be fragile by external loads, shocks and frictions and their electrical performance may easily be deteriorated by the external environmental changes such as humidity, an insulating substance is coated on the ceramic chip and the connection region between the ceramic chip and the lead wire after the lead wire is soldered to the ceramic chip.

The ceramic chip assembly must easily be electrically and mechanically connected to a PCB, and satisfy various reliable characteristics. Additionally, the ceramic chip assembly must be manufactured in a reel taping manner, be cost-saving, and be automatically mounted onto the PCB. Furthermore, with the developments of recent electronic and communication technologies, these ceramic chip assemblies must have lightweight and slim profile and have high reliability against external environments.

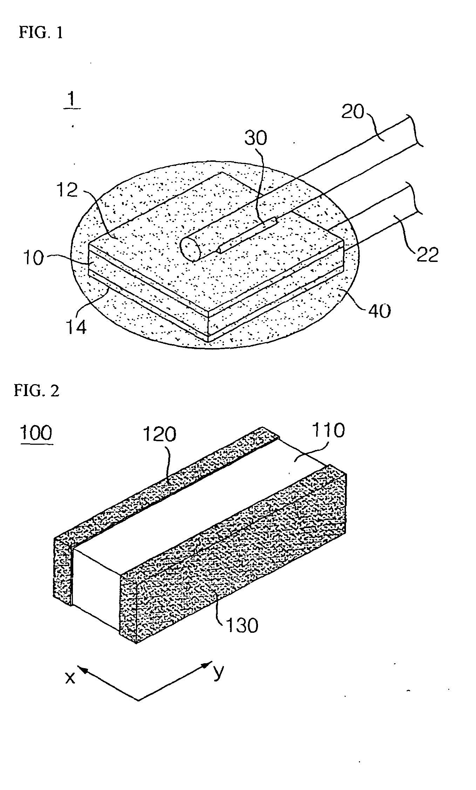

FIG. 1 is a view illustrating a related-art ceramic chip assembly in which a cylindrical metal lead wire and ceramic chip components are coupled to each other through a soldering method.

Referring to FIG. 1, external electrodes 12 and 14 are formed on one surface and the other surface of a ceramic bare chip 10. Ends of lead wires 20 and 22 are fixed on the external electrodes 12 and 14 through a solder. The ceramic bare chip 10 and the ends of the lead wires 20 and 22 are surrounded by an insulating protection layer 40 such as an epoxy, which is formed by a coating or dipping method.

Generally, the ceramic bare chip 10 has a thin thickness, and includes only the external electrodes 12 and 14, and not an internal electrode. These external electrodes 12 and 14 are usually formed on one surface and the other surface of the ceramic bare chip 10 having a relatively broad area. Thus, the ceramic bare chip 10 without any internal electrode may not have various electrical characteristics.

The metal lead wires 20 and 22 have a cylindrical shape that makes it possible to be cost-saving and easily-automated. Generally, the diameter of the metal lead wire ranges from about 0.15mm to about 0.5mm.

However, there are the following limitations in the related-art.

First, the insulating protection layer 40 such as an epoxy formed to protect all of the ceramic bare chip 10 and a part of the lead wires 20 and 22 increases the thickness of the ceramic chip assembly 1 due to the lead wires 20 and 22 formed on one surface and the other surface of the ceramic bare chip 10.

Also, due to the lead wires 20 and 22 disposed on one surface and the other surface of the ceramic bare chip 10, external loads, shocks, and frictions exerted on both surfaces of the ceramic bare chip 10 are concentrated on the protruded lead wires 20 and 22. Accordingly, the ceramic bare chip 10 under the lead wires 20 and 22 may be fragile.

Furthermore, since the ceramic bare chip 10 may be usually formed of only semiconductor materials, the ceramic bare chip 10 has a weak mechanical strength against external shocks or frictions.

Since the size of the ceramic bare chip 10 is usually greater than the external diameter of the lead wires 20 and 22, the ceramic bare chip 10 has a difficulty in protection from external loads, shocks, and frictions. Also, this is not suitable for a ceramic bare chip having lightweight and slim profile.

For example, a ceramic chip assembly having the properties of a thermistor is inserted under a CPU to measure the temperature of a CPU of a computer. In this case, the ceramic chip assembly must be thin, mechanically strong, and cost-saving. Also, the surface of the ceramic chip assembly must be even. However, a related-art structure of the ceramic chip assembly is difficult to satisfy these characteristics.

On the other hand, in the related-art structure of the ceramic chip assembly, a sheet-shaped lead frame where a thin metal film having a thickness of about 0.15 mm is formed through an etching or pressing may be used to reduce the thickness of the ceramic chip assembly instead of cylindrical lead wires 20 and 22. The ceramic bare chip 10 or a ceramic chip including an external electrode having a length, thickness, and width of about 1mm, about 0.35mm, about 0.5mm, respectively may be used. A pair of insulating films including a hot melt adhesive may be used as an insulating protection layer 40 to seal the ceramic bare chip 10 by heat and pressure.

However, according to the modified structure, the price of the lead frame is more expensive than cylindrical metal lead wire, and continuous production in reel taping manner is difficult. Furthermore, the section of the lead frame has a rectangular shape of a relatively thin thickness of, for example, about 0.15mm, and a relatively broad width of, for example, about 0.5mm usually. The thickness of a ceramic bare chip or a ceramic chip that is inserted between the lead frames is thicker than the lead frame, so that a protruded part thereof may be easily broken or damaged by external loads, shocks, or frictions. That is, since the lead frame has a relatively thin thickness, the lead frame has a limitation in physically protecting the ceramic bare chip or the ceramic chip from horizontal or vertical shocks or frictions. On the other hand, even when the thickness part of the lead frame is upright in a width direction so as to contact with the ceramic bare chip 10 or the ceramic chip, it is difficult to protect the ceramic chip from external load, shocks, or frictions that are exerted along the vertical direction of the ceramic chip assembly.

Also, the lead frame has a rectangular shape and the external electrode of the ceramic chip having a rectangular structure are contacted with each other at a soldered part, which is formed in a straight line. Thus, the area occupied by the soldered part is so small that the soldering strength may be weak.

In addiction, since the structure of the lead frame has a rectangular shape, it is inefficient to insert the lead frame into a circular hole of the PCB for soldering. Since the thin plate lead frame has a tendency to be recovered by its elasticity until being completely bent, the lead frame is difficult to fix at a certain spot. Also, the lead frame may easily be cut off in a thin thickness direction.

Furthermore, since a hot melt adhesive is melted by heat, the adhesive strength may be significantly reduced at a high temperature, making it difficult to protect the ceramic chip.

Moreover, the ceramic chip applied to the lead frame is a ceramic bare chip having a mono-layer of a thin thickness that does not include an internal electrode formed therein, making it difficult to provide a ceramic chip assembly having various performances.

### Summary of the Invention

An object of the present invention is to provide a ceramic chip assembly having a thin thickness.

Another object of the present invention is to provide a ceramic chip assembly protecting damages from external loads, shocks, and frictions.

A further another object of the present invention is to provide a ceramic chip assembly having an electrically and mechanically strong adhesive strength between a lead wire and a ceramic chip.

A further another object of the present invention is to provide a ceramic chip assembly that can be economically and automatically manufactured in a reel taping manner.

A further another object of the present invention is to provide a ceramic chip assembly including an insulating protection layer having a uniform thickness.

A further another object of the present invention is to provide a ceramic chip assembly that can reliably protect an internal ceramic chip from the external environment.

A further another object of the present invention is to provide a ceramic chip assembly that can be used at a high temperature.

A further another object of the present invention is to provide a ceramic chip assembly that has the same upper and lower structures to improve the productivity.

A further another object of the present invention is to provide a ceramic chip assembly that can realize various electrical characteristics by internal electrodes of a ceramic chip.

A further another object of the present invention is to provide a ceramic chip assembly, where a lead wire is easily inserted into a PCB to be soldered, has little tendency to be returned by elasticity to be easily secured at a certain part, and is not easily cut off by a repeated force.

According to an aspect of the present invention, there is provided a ceramic chip assembly including: a ceramic base having electrical characteristics of a semiconductor; a pair of external electrodes oppositely formed on both side surfaces of the ceramic base, respectively; a pair of cylindrical metal lead wires having one end thereof electrically and mechanically connected to the external electrodes by an electrical conductive adhesive, respectively, and having an external diameter identical to or greater than the thickness of the ceramic base; and an insulating protection material sealing the ceramic base, the external electrodes, the electrical conductive adhesive, and the metal lead wires by being attached to each other through an insulating adhesive while exposing other ends of the metal lead wires to the outside, wherein the insulating protection material comprises one of a pair of insulating films and an insulating coating layer.

The thickness of the ceramic base may range from about 0.2mm to about 0.6mm, the length of the ceramic base may be greater than the thickness or the width of the ceramic base, and the lead wire may be extended in the longitudinal direction of the ceramic base to be connected to the external electrode.

The ceramic base may include an internal electrode formed therein and electrically connected to the external electrode.

The ceramic base may be one of a thermistor, a magnetic substance, or a piezoelectric.

The center of the section of the lead wire may be located at a line extended from the center of the thickness of the ceramic base to allow upper and lower parts of the ceramic chip to have the same shape.

The ceramic base may be formed to have a thin thickness on an insulating alumina substrate.

The insulating adhesive may be one of a thermoplastic hot melt and a thermosetting adhesive.

The adhesion by the electrical conductive adhesive may be achieved by one of a soldering using a solder cream, an adhesion using an electrical conductive polymer adhesive, and a spot welding.

The insulating film may be one of polyethyleneterephthalate (PET), polyethylenenaphthalate (PEN), polyimide (PI), and polytetrafluoroethylene (PTFE) films having a thickness from about 0.015mm to about 0.07mm.

The insulating film may be one of a thermosetting polymer resin or a glass.

The one end of the lead wire may be more protruded than the ceramic base.

The lead wire may be coated for insulation except a part that is connected to the external electrode.

The ceramic chip assembly may be supplied through reel taping by a carrier tape.

According to another aspect of the present invention, there is provided a ceramic chip assembly including: a ceramic base having electrical characteristics of a semiconductor; a pair of external electrodes oppositely formed on both side surfaces of the ceramic base, respectively; a pair of cylindrical metal lead wires having one end thereof electrically and mechanically connected to the external electrodes by an electrical conductive adhesive, respectively, and having an external diameter identical to or greater than the thickness of the ceramic base; an insulating coating layer sealing the ceramic base, the external electrodes, the electrical conductive adhesive, and the metal lead wires while exposing other ends of the metal lead wires to the outside; and a pair of insulating films covering the insulating coating layer by being attached to each other through an insulating adhesive.

There is provided a method of manufacturing a ceramic chip assembly, including: continuously supplying a ceramic base including external electrodes formed on both side surfaces thereof and having electrical characteristics of a semiconductor; maintaining a cylindrical metal lead wire to be contacted with the external electrodes by forming the continuously-reeled cylindrical metal lead wire into a curved form using a carrier tape; adhering the metal lead wire to the external electrodes of the ceramic base using an electrical conductive adhesive; mechanically and electrically separating the metal lead wire by cutting off the curved part of the metal lead wire after the external electrode is electrically and mechanically connected to the metal lead wire using the electrical conductive adhesive; and sealing the ceramic base, the external electrode, the electrical conductive adhesive, and the metal lead wire by heat and pressure using a pair of insulating films coated with an insulating adhesive, exposing other end of the metal lead wire to the outside.

The method may further include automatically and continuously sorting by connecting a measurer to both ends of the lead wire that is not sealed by the insulating film.

There is provided a method of manufacturing a ceramic chip assembly, including: continuously supplying a ceramic base including external electrodes formed on both side surfaces thereof and having electrical characteristics of a semiconductor; maintaining a cylindrical metal lead wire to be contacted with the external electrodes by forming the continuously-reeled cylindrical metal lead wire into a curved form using a carrier tape; adhering the metal lead wire to the external electrodes of the ceramic base using an electrical conductive adhesive; mechanically and electrically separating the metal lead wire by cutting off the curved part of the metal lead wire after the external electrode is electrically and mechanically connected to the metal lead wire using the electrical conductive adhesive; sealing the ceramic base, the external electrode, the electrical conductive adhesive, and the metal lead wire by dipping into a liquefied insulating coating adhesive, exposing other end of the metal lead wire to the outside; and forming a solidified insulating coating layer by hardening the insulating coating adhesive.

The method may further include automatically and continuously sorting by connecting a measurer to both ends of the lead wire that is not sealed by the insulating film.

### Brief Description of the Drawings

The above objects and other advantages of the present invention will become more apparent by describing in detail preferred embodiments thereof with reference to the attached drawings in which:

FIG. 1 is a view illustrating a related-art ceramic chip assembly in which a cylindrical metal lead wire and ceramic chip components are coupled to each other through a soldering method.

FIG. 2 is a view illustrating an exemplary ceramic chip applied to a ceramic chip assembly according to an embodiment.

FIG. 3 is a view illustrating a ceramic chip assembly according to an embodiment.

FIG. 4 is a cross-sectional view taken along the line 4-4 of FIG. 3.

FIG. 5 is a plan view of FIG. 3.

FIG. 6 is a view illustrating a ceramic chip assembly according to another embodiment.

### Detailed Description of the preferred Embodiment

Now, preferred embodiments of the present invention will be described in detail with reference to the accompanying drawings.

FIG. 2 is a view illustrating an exemplary ceramic chip 100 applied to a ceramic chip assembly according to an embodiment.

Referring to FIG. 2, the ceramic chip 100 includes a ceramic base 110 and external electrodes 120 and 130.

The ceramic base 110 has a hexahedral shape and electrical characteristics. The external electrodes 120 and 130 are oppositely formed on both side surfaces of the ceramic base 110.

According to an embodiment, the size, the thickness, and the width of the ceramic chip 100 may be about 1mm, about 0.30mm, and about 0.5mm, respectively, but is not limited thereto.

If the size of the ceramic chip 100 is too small, the automation by a real taping may be difficult when the ceramic chip assembly is manufactured.

The external electrodes 120 and 130 may be formed on both ends of the ceramic base 110 in a smaller width direction, X-axis direction.

An internal electrode may be formed in the ceramic base. Both ends of the internal electrode may be electrically connected between the external electrodes 120 and 130.

One surface and the other surface of the ceramic chip 100 are flat, which is a Surface Mount Device (SMD) ceramic chip that can be surface-mounted by a vacuum pickup.

Thus, the hexahedral ceramic chip 100 has lightweight and slim profile to be advantageously automated, sorted by an automated sorter, and cost-saving. Also, the ceramic chip 100 includes an internal electrode to realize more various electrical characteristics. That is, the semiconductor ceramic base 110 can have precise electrical characteristics by the internal electrode. Also, the electrical capacity can easily be controlled.

The ceramic chip 100 may include a semiconductor ceramic base 110 formed on an insulating alumina substrate. In this case, the thickness of the alumina substrate may range from about 0.2mm to about 0.4mm. The thickness of the semiconductor ceramic base 110 may range from about 0.02mm to about 0.1mm. Accordingly, the mechanical strength of the ceramic chip 100 against external loads, shocks, and frictions may be improved by the alumina substrate.

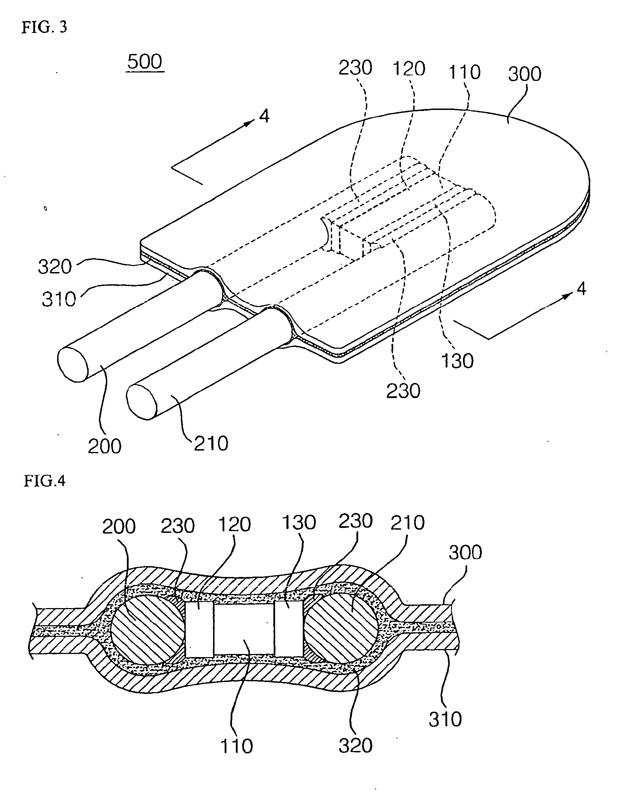

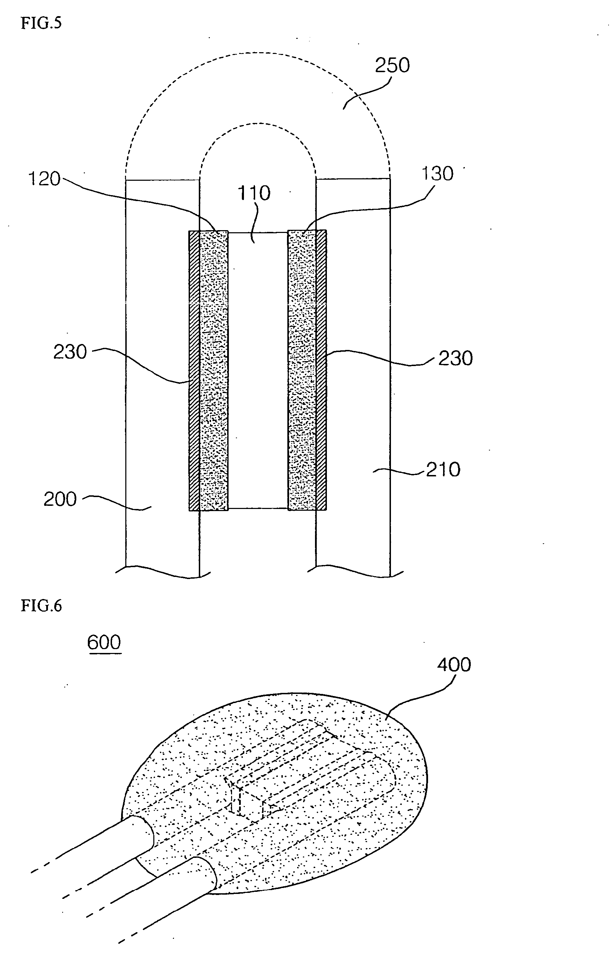

FIG. 3 is a view illustrating a ceramic chip assembly according to an embodiment. FIG. 4 is a cross-sectional view taken along the line 4-4 of FIG. 3. FIG. 5 is a plan view of FIG. 3.

Referring to FIG. 3, metal lead wires 200 and 210 having a cylindrical shape are mechanically and electrically connected to the outer side surfaces of the external electrodes 120 and 130 of the ceramic base 110 by an electrical conductive adhesive, for example, a solder 230. Also, the ceramic base 110, the external electrodes 120 and 130, and a part of the lead wires 200 and 210 are sealed by heat and pressure using a pair of insulating films 300 and 310. The pair of the insulating films 300 and 310 is adhered to each other through an insulating adhesive 320.

The center of the section of the lead wires 200 and 210 may be located at the line extended from the center of the thickness of the ceramic base 110. In this case, the shapes of the upper and lower parts of the ceramic chip assembly 500 are identical to each other, thereby improving the productivity and protecting the ceramic chip 100 from external loads, shocks, and frictions that exerted upwardly and downwardly.

The material and thickness of the pair of the insulating films 300 and 310 may be identical to each other, and the material and thickness of the metal lead wires 200 and 210 are also identical to each other.

The diameter of the metal lead wires 200 and 210 having a cylindrical shape may be identical to or greater than the thickness of the ceramic base 110.

The length of the ceramic base 110 may be greater than the width or the thickness of the ceramic base 110.

The ceramic chip 100 may be protected from changes of external environment such as humidity by the insulating adhesive 320 formed between the insulating films 300 and 310.

Ceramic Chip 100

The ceramic chip 100 includes the ceramic base 110 and the external electrodes 120 and 130 that are mechanically and electrically connected to both side surfaces of the ceramic base 110. As described above, the external electrodes 120 and 130 are oppositely formed at both ends of the ceramic base 110 in the width direction of the ceramic base 110.

The ceramic base 110 may be a fired ceramic having electrical characteristics. The ceramic base 110 may be a semiconductor ceramic having the characteristics of a thermistor, a magnetic substance, or a piezoelectric. The ceramic base 110 may be a multi-layer semiconductor ceramic where one of a thermistor, a magnetic substance, or a piezoelectric is formed on an insulating ceramic substrate.

The ceramic base 110 may be a hexahedron, one surface and the other surface of which are parallel to each other, and can be surface-mounted. For example, the width of the ceramic base 110 may range from about 0.25mm to about 0.8mm, the thickness of the ceramic base 110 may range from about 0.20mm to about 0.6mm, and the length of the ceramic base 110 may range from about 0.5mm to about 1.6mm.

The center of the section of the leas wires 200 and 210 may be located at the line extended from the center of the thickness of the ceramic base 110 to allow the upper and lower parts of the ceramic chip assembly 500 to be identical to each other.

The external electrodes 120 and 130 are formed at both ends of the width direction (X-direction of FIG. 2) of the ceramic base 110 to tightly attach the lead wires 200 and 210 to the external electrode 120 and 130 by an electrical conductive adhesive means 230. In this case, since the lease wires 200 and 210 are extended in the longitudinal direction (Y-direction of FIG. 2) of the ceramic base 110, the contact area between the lead wires 200 and 210 and the ceramic base 110 may be increased. Here, the ceramic chip assembly 500 may have a narrower width and a smaller thickness, resulting in more various performances.

The ceramic base 110 may have a mono- or multi-layer type, or may be a semiconductor ceramic formed on an insulating ceramic substrate such as an alumina substrate to enhance the mechanical strength.

The ceramic base 110 may include an internal electrode. If the ceramic base 110 includes an internal electrode, the internal electrode is electrically connected to the external electrodes 120 and 130. If the ceramic base 110 includes an internal electrode that is not shown in the drawings, then precise electrical characteristics may easily be provided, and also the electrical capacity may easily be controlled.

The external electrodes 120 and 130, which are parts where the lead wires 200 and 210 are fixed through a solder, serve as an electrical path to the outside. For example, the external electrodes 120 and 130 may be formed by dipping both side surfaces of the ceramic base 110 into metal paste and then plating with Ni and Sn.

Cylindrical Metal Lead Wires 200 and 210

The cylindrical metal lead wires 200 and 210 serves to deliver the electrical characteristics of the ceramic base 110 to a demanding part through the external electrodes 120 and 130 and the solder 230.

In consideration of the mechanical strength and the electrical conductivity, the metal lead wires 200 and 210 may be formed of one of Cu or an alloy thereof, Fe or an alloy thereof, and Ni or an alloy thereof. When an insulating wire having an insulating protection layer is used as the lead wires 200 and 210, the insulating wire of a soldered part and a part soldered on PCB is removed thermally and mechanically before use. In this case, the insulating wire may be an insulating enamel wire.

For a good adhesive strength with the external electrodes 120 and 130 and automation such as reel taping, cylindrical lead wire may be used as the lead wires 200 and 210. Furthermore, if a cylindrical metal wire is used, then the distortion of the lead wires 200 and 210 does not occur during continuous manufacturing process. Thus, job efficiency is enhanced, and the lead wires 200 and 210 may easily be inserted and soldered into the holes of PCB.

However, if necessary, the shape of the section of a part of the cylindrical metal lead wire may be replaced with other shapes. For example, a part of the cylindrical metal lead wire that exists in the insulating film except a part contacting the external electrodes 120 and 130 is stamped in opposite directions up and down, so that the metal lead wires 200 and 210 may have a flat rectangular sectional shape. Accordingly, the present invention includes all cases of continuously using metal lead wires 200 and 210 having a circular section.

Referring to FIG. 4, if the section of the metal leas wires 200 and 210 is circular, a space having a great volume is formed around the contact part between the lead wires 200 and 210 and the external electrodes 120 and 130. The space is filled with an electrical conductive adhesive means, for example, a solder 230, thereby increasing an adhesive strength, that is, a soldering strength between the lead wires 200 and 210 and the external electrodes 120 and 130.

As described in FIG. 4, by using the diameter of the cylindrical metal lead wires 200 and 210 identical to or greater than the thickness of the ceramic base 110, if vertical pressure or shock from the outside is exerted, the pressure and the shock is dispersed to the lead wires 200 and 210, thereby protecting the ceramic base 110 having a low mechanical strength from external loads, shocks, and frictions.

Also, the ceramic base 110 may be protected from pressure or shock that is horizontally exerted.

Smooth insulating films 300 and 310 may be formed on the ceramic base 110 and the lead wires 200 and 210. This allows the ceramic chip assembly 500 to be easily inserted into a narrow gap between structures.

As described above, since the external electrodes 120 and 130 and the lead wires 200 and 210 are soldered in the longitudinal direction of the ceramic base 110, the contact area therebetween are increased to enhance the reliability and the strength of the soldering.

The cylindrical metal lead wires 200 and 210 are more cost-saving and easier to automate than a lead frame that is pressed or etched in a rectangular sectional shape, thereby providing an economic ceramic chip assembly 500.

The cylindrical metal lead wires 200 and 210 may easily be inserted and soldered into a circular hole, for example, a via hole of PCB. Since the cylindrical metal lead wires 200 and 210 have a uniform thickness, the cylindrical metal lead wires 200 and 210 have little tendency to be recovered by elasticity before being completely bent, and therefore may easily be secured at a certain part and may not be easily cut off by repeated forces.

In the manufacturing of the ceramic chip assembly 500, while the cylindrical metal lead wires 200 and 210 are continuously reeled together with a carrier tape, as described in FIG. 5, the lead wires 200 and 210 are physically formed to be contacted with the external electrodes 120 and 130 of the ceramic chip 100 through a continuous forming process of using the carrier tape. Then, after the lead wires 200 and 210 and the external electrodes 120 and 130 are impregnated with a solder 230 in a melted solder vessel, both ends of the formed part 250 of the lead wires 200 and 210 are automatically cut off by a press. Thus, as described in FIG. 5, the cut ends of the lead wires 200 and 210 may be more protruded than the ceramic base 110. According to the above configuration, the protruded part of the lead wires 200 and 210 may protect the ceramic chip 100 when the ceramic chip assembly 500 is inserted into a narrow gap with the protruded part of the lead wires 200 and 210 at the head of the ceramic chip assembly 500.

The mechanical coupling between the lead wires 200 and 210 and the external electrodes 120 and 130 before soldering may be achieved by a pressure of the formed part 250 of the lead wire. Thus, the lead wires 200 and 210 are formed of one type of lead wire that is continuously supplied. The thickness and the material of the lead wires 200 and 210 are uniform.

Although not shown, the carrier tape is supplied to continuously manufacture the ceramic chip assembly 500. Particularly, the carrier tape is necessary when the both formed ends of the lead wires 200 and 210 are cut. The carrier tape may be formed of a paper or a synthetic resin film.

The diameter of the metal lead wires 200 and 210 may range from about 0.2mm to about 0.6mm.

Electrical Conductive Adhesive Means 230

The electrical conductive adhesive means 230 serves to electrically and mechanically connect the lead wires 200 and 210 and the external electrodes 120 and 130 of the ceramic base 110.

When the ceramic chip assembly 500 is used at a low temperature of, for example, less than about 200 °C, the electrical conductive adhesive means 230 may be a general cost-saving and convenient solder.

If the lead wires 200 and 210 including the ceramic chip 110 inserted therebetween are continuously put into a solder-melted vessel, the external electrodes 120 and 130, and the lead wires 200 and 210 are automatically soldered by the solder 230.

When the ceramic chip assembly 500 is used at a high temperature of more than about 200 °C, thermosetting electrical conductive high-temperature epoxy adhesive or spot welding may be applied to the electrical conductive means 230. In this case, the electrical conductive adhesive means 230 may provide a reliable electrical and mechanical adhesive property even at a high temperature.

The electrical conductive adhesive means 230 may be achieved by common adhesive technology and material.

Insulating Films 300 and 310

The insulating films 300 and 310 have a pair of insulating film tapes attached to each other by heat and pressure. One surface of the insulating film tape is coated with an insulating adhesive 320 such as a hot melt adhesive and a thermosetting adhesive. When the hot melt adhesive is used, the hot melt adhesive may be re-melted by heat. Accordingly, when the ceramic chip assembly is used at a high temperature, the adhesive strength may be reduced by heat, making it difficult to protect the ceramic base.

The hot melt adhesive may be an EVA, polyurethane, or polyester adhesive.

Since the thermosetting adhesive is not melt by heat, the thermosetting adhesive may be used at a high temperature. Particularly, a thermosetting silicon rubber adhesive is flexible, elastic, and water-proofing.

A liquefied thermosetting adhesive may be cast or coated on the insulating films 300 and 310 and then be hardened during the manufacturing process of the ceramic chip assembly 500.

In this case, the part where the ceramic base 110 is located is completely sealed by the insulating films 300 and 310 and the insulating adhesive 320, and outer ends of the lead wires 200 and 210 are exposed. In this structure, the ceramic chip 100 and the soldered part may be protected from the outside, and a certain part of the lead wires 200 and 210 may be insulated.

Generally, since the insulating films 300 and 310 have a thin and uniform thickness, economic insulation efficiency and work efficiency may be reliably provided.

Furthermore, when the ceramic chip assembly 500 is inserted into a thin gap of structures, the smooth surface of the insulating films 300 and 310 may reduce the friction with external material, and avoid the concentration of external pressure.

The insulating films 300 and 310 may be formed of a heat-resistant film such as Teflon, polyester, or polyamide. The thickness of the insulating films 300 and 310 may range from about 0.01mm to about 0.08mm.

The insulating films 300 and 310 and the insulating adhesive 320 has a heat-resistant condition that may satisfies the soldering condition for a short duration between both ends of the lead wires 200 and 210 not covered with the insulating films 300 and 310 and a PCB.

Although the insulating films 300 and 310 are applied to the ceramic chip assembly 500 as an example, an insulating coating layer with an insulating coating adhesive may be used instead of the insulating films 300 and 310. FIG. 6 is a view illustrating a ceramic chip assembly according to another embodiment.

More specifically, an insulating coating layer 400 may be formed by performing a thin insulation coating on a ceramic chip, a solder, and lead wires except both ends thereof using a thermosetting insulation coating adhesive such as an epoxy or a silicon rubber. For this, the process of forming the insulating coating layer 400 may include dipping it into a liquefied silicon rubber or coating epoxy powder on it, coating an insulating epoxy and an insulating silicon rubber on it, and then hardening it by heat.

The insulating coating layer 400 may be one of a thermosetting epoxy resin, a silicon rubber, or a glass.

Compared to an expensive insulating film, this structure may reduce the total size of the ceramic chip assembly and the manufacturing cost.

Also, by this structure, very small dimensional ceramic chip assembly 600 may be manufactured, and particularly, the width and thickness of the ceramic chip assembly 600 may be very small.

Since the insulating coating layer 400 is formed of a thermosetting resin, the insulating coating layer 400 is not re-melted by heat, thereby providing reliable property and increasing its usefulness at a high temperature.

The insulating coating layer 400 between two lead wires 200 and 210 protects a force widening a space between both ends of the lead wires 200 and 210 from being delivered to the soldered part, thereby assuring the connection between the lead wires 200 and 210 and the external electrodes 120 and 130.

For more reliable insulating sealing and protection of the ceramic chip 100 from external loads, shock, and frictions, the insulating films 300 and 310 may be again applied to the insulating coating layer 400 after the insulating coating layer 400 is formed by performing a thin insulation coating on a ceramic chip, a solder, and lead wires except both ends thereof using a thermosetting insulation coating adhesive such as an epoxy or a silicon rubber.

In this case, more reliable insulating sealing may be achieved by the insulating coating layer 400 and the insulating films 300 and 310, and the ceramic chip 100 and the solder part may be protected from external loads, shocks, and frictions.

The embodiments can achieve the following effects.

Since cylindrical metal lead wires are disposed at external electrodes on both side surfaces of the ceramic base, and the diameter of the lead wire is identical to or greater than the thickness of the ceramic base, external loads, shocks, and frictions are absorbed and dispersed into the lead wires, thereby protecting the ceramic chip from the external pressure, shock, and friction.

Since the cylindrical metal lead wires are electrically and mechanically adhere to the external electrodes along the longitudinal direction of the ceramic base, the contact area is broad, thereby increasing the adhesion strength and reducing the thickness of a ceramic chip assembly.

The cylindrical metal lead wire enables easy reel taping and automation, and reduction of the manufacturing cost.

Various electrical characteristics can be realized by forming an internal electrode in the ceramic base.

The strength of a ceramic is improved because the ceramic is formed on an insulating ceramic base having a high mechanical strength.

An insulating protection layer having a uniform thickness can be provided by using an insulating film. Smooth surface of the insulating film helps to endure external friction.

If an insulting adhesive and an insulating coating layer are thermosetting, they are not re-melted, thereby maintaining reliable adhesive strength at a high temperature.

A hot melt adhesive used as an insulating adhesive is cost-saving and productive.

If an insulating coating layer is formed in the insulating film, the ceramic chip can be more reliably protected from external environmental change. Also, when two lead wires are widened by force, the ceramic chip can be protected.

The cylindrical metal lead wire can easily be inserted and soldered into a circular hole of a PCB. Also, since the cylindrical metal lead wire has little tendency to be recovered by elasticity even before being completely bent, the cylindrical metal lead wire can easily be secured at a certain part, and may not easily be cut off by repeated forces.

A polymer adhesive that is thermosetting and electrically conductive and a spot welding method may easily be used at a high temperature.

Since the center of the lead wire is located at the line extended from the center of the thickness of the ceramic base, the upper and lower parts of the ceramic chip assembly are identical to each other, facilitating automation and use thereof.

While the present invention has been described in detail, it should be understood that various changes, substitutions and alterations can be made hereto without departing from the scope of the invention as defined by the appended claims. For example, lead wires may be arbitrarily bent in an insulating film. Accordingly, the scope of the present invention should not be construed as limited to the embodiments, but rather should be determined by the accompanying claims.

## Claims

1. A ceramic chip assembly comprising:
a ceramic base (110) having electrical characteristics of a semiconductor;
a pair of external electrodes (120, 130) oppositely formed on both side surfaces of the ceramic base, respectively;
a pair of metal lead wires (200, 210) having one end thereof electrically and mechanically connected to the external electrodes by an electrical conductive adhesive (230) respectively; and
an insulating protection material sealing the ceramic base, the external electrodes, the electrical conductive adhesive, and the metal lead wires while exposing other ends of the metal lead wires to the outside,
wherein the insulating protection material comprises one of a pair of insulating films (300, 310) by being attached to each other through an insulating adhesive (320), an insulating coating layer (400), and a pair of insulating films (300, 310) covering an insulating coating layer (400) by being attached to each other through an insulating adhesive (320),
**characterized in that**
the pair of metal lead wires is a pair of cylindrical metal lead wires, and
the cylindrical metal lead wires have an external diameter identical to or greater than the thickness of the ceramic base.

2. The ceramic chip assembly of claim 1, wherein the thickness of the ceramic base ranges from about 0.2mm to about 0.6mm, the length of the ceramic base is greater than the thickness or the width of the ceramic base, and the lead wire is extended in the longitudinal direction of the ceramic base to be connected to the external electrode.

3. The ceramic chip assembly of claim 1, wherein the ceramic base comprises an internal electrode formed therein and electrically connected to the external electrode.

4. The ceramic chip assembly of claim 1, wherein the ceramic base is one of a thermistor, a magnetic substance, and a piezoelectric.

5. The ceramic chip assembly of claim 1, wherein the center of the section of the lead wire is located at a line extended from the center of the thickness of the ceramic base to allow upper and lower parts of the ceramic chip to have the same shape.

6. The ceramic chip assembly of claim 1, wherein the ceramic base is formed to have a thin thickness on an insulating alumina substrate.

7. The ceramic chip assembly of claim 1, wherein the insulating adhesive is one of a thermoplastic hot melt and a thermosetting adhesive.

8. The ceramic chip assembly of claim 1, wherein the adhesion by the electrical conductive adhesive is achieved by one of a soldering using a solder cream, an adhesion using an electrical conductive polymer adhesive, and a spot welding.

9. The ceramic chip assembly of claim 1, wherein the insulating film is one of polyethyleneterephthalate (PET), polyethylenenaphthalate (PEN), polyimide (PI), and polytetrafluoroethylene (PTFE) films having a thickness from about 0.015mm to about 0.07mm.

10. The ceramic chip assembly of claim 1, wherein the insulating film is one of a thermosetting polymer resin or a glass.

11. The ceramic chip assembly of claim 1, wherein the one end of the lead wire is more protruded than the ceramic base.

12. The ceramic chip assembly of claim 1, wherein the cylindrical metal lead wires comprise portions thereof formed in a different sectional shape.

## Patentansprüche

1. Keramikchip-Anordnung, aufweisend:
eine Keramikbasis (110) mit elektrischen Eigenschaften eines Halbleiters;
ein Paar von äußeren Elektroden (120, 130), die jeweils auf zwei seitlichen Oberflächen der Keramikbasis einander gegenüberliegend ausgebildet sind;
ein Paar von Metallleitungsdrähten (200, 210), bei denen ein Ende derselben jeweils mit den äußeren Elektroden durch einen elektrisch leitfähigen Klebstoff (130) elektrisch und mechanisch verbunden ist; und
ein isolierendes Schutzmaterial, das die Keramikbasis, die äußeren Elektroden, den elektrisch leitfähigen Klebstoff und die Metallleitungsdrähte abdichtet, während es die anderen Enden der Metallleitungsdrähte nach außen freilegt,
wobei das isolierende Schutzmaterial entweder ein Paar von isolierenden Schichten (300, 310), indem sie über einen isolierenden Klebstoff (320) aneinander angebracht sind, eine Lage (400) einer isolierenden Beschichtung und/oder ein Paar von isolierenden Schichten (300, 310), die eine Lage (400) einer isolierenden Beschichtung bedecken, indem sie über einen isolierenden Klebstoff (320) aneinander angebracht sind,
**dadurch gekennzeichnet, dass**
das Paar von Metallleitungsdrähten ein Paar aus zylindrischen Metallleitungsdrähten ist, und
die zylindrischen Metallleitungsdrähte einen äußeren Durchmesser aufweisen, der größer oder gleich der Dicke der Keramikbasis ist.

2. Keramikchipanordnung nach Anspruch 1, wobei die Dicke der Keramikbasis von etwa 0,2 mm bis etwa 0,6 mm reicht, die Länge der Keramikbasis größer als die Dicke oder die Breite der Keramikbasis ist, und der Leitungsdraht so in der Längsrichtung der Keramikbasis verläuft, dass er mit der äußeren Elektrode verbunden ist.

3. Keramikchipanordnung nach Anspruch 1, wobei die Keramikbasis eine darin ausgebildete innere Elektrode aufweist, die mit der äußeren Elektrode elektrisch verbunden ist.

4. Keramikchipanordnung nach Anspruch 1, wobei die Keramikbasis entweder ein Thermistor, eine magnetische Substanz und/oder piezoelektrisch ist.

5. Keramikchipanordnung nach Anspruch 1, wobei der Mittelpunkt des Abschnitts des Leitungsdrahtes sich auf einer Linie befindet, die von dem Mittelpunkt der Dicke der Keramikbasis so verläuft, dass ein oberer und ein unterer Teil des Keramikchips die gleiche Form aufweisen können.

6. Keramikchipanordnung nach Anspruch 1, wobei die Keramikbasis so ausgebildet ist, dass sie auf einem isolierenden Aluminiumoxidsubstrat eine geringe Dicke aufweist.

7. Keramikchipanordnung nach Anspruch 1, wobei der isolierende Klebstoff entweder ein thermoplastischer Schmelzklebstoff oder ein duroplastischer Klebstoff ist.

8. Keramikchipanordnung nach Anspruch 1, wobei die Adhäsion durch den elektrisch leitfähigen Klebstoff entweder durch Löten unter Verwendung einer Lötpaste, eine Adhäsion unter Verwendung eines elektrisch leitfähigen Polymerklebstoffs und/oder Punktschweißen erreicht wird.

9. Keramikchipanordnung nach Anspruch 1, wobei die isolierende Schicht entweder ein Polyethyleneterephthalat (PET), ein Polyethylenaphthalat (PEN), ein Poylimid (PI) und/oder Polytetrafluorethylen- (PTFE-) Schichten mit einer Dicke von etwa 0,015 mm bis etwa 0,07 mm ist.

10. Keramikchipanordnung nach Anspruch 1, wobei die isolierende Schicht entweder ein duroplastisches Polymerharz oder ein Glas ist.

11. Keramikchipanordnung nach Anspruch 1, wobei das eine Ende des Leitungsdrahtes aus der Keramikbasis stärker herausragt.

12. Keramikchipanordnung nach Anspruch 1, wobei die zylindrischen Metallleitungsdrähte Bereiche aufweisen, deren Querschnitt unterschiedlich ausgebildet ist.

## Revendications

1. Ensemble de puce en céramique comprenant :
une base en céramique (110) ayant les caractéristiques électriques d'un semi-conducteur ;
une paire d'électrodes externes (120, 130) formées de façon opposée sur les deux surfaces latérales de la base en céramique, respectivement ;
une paire de fils conducteurs en métal (200, 210) ayant une extrémité de ceux-ci raccordée électriquement et mécaniquement aux électrodes externes par un adhésif électriquement conducteur (230), respectivement ; et
un matériau de protection isolant étanchéifiant la base en céramique, les électrodes externes, l'adhésif électriquement conducteur, et les fils conducteurs en métal tout en exposant les autres extrémités des fils conducteurs en métal à l'extérieur,
dans lequel le matériau de protection isolant comprend l'un d'une paire de films isolants (300, 310) en étant fixés l'un à l'autre par l'intermédiaire d'un adhésif isolant (320), d'une couche de revêtement isolante (400), et d'une paire de films isolants (300, 310) recouvrant une couche de revêtement isolante (400) en étant fixés l'un à l'autre par l'intermédiaire d'un adhésif isolant (320),
**caractérisé en ce que**
la paire de fils conducteurs en métal est une paire de fils conducteurs en métal cylindriques, et
les fils conducteurs en métal cylindriques ont un diamètre externe identique ou supérieur à l'épaisseur de la base en céramique.

2. Ensemble de puce en céramique selon la revendication 1, dans lequel l'épaisseur de la base en céramique varie d'environ 0,2 mm à environ 0,6 mm, la longueur de la base en céramique est supérieure à l'épaisseur ou la largeur de la base en céramique, et le fil conducteur est étendu dans la direction longitudinale de la base en céramique pour être raccordé à l'électrode externe.

3. Ensemble de puce en céramique selon la revendication 1, dans lequel la base en céramique comprend une électrode interne formée dans celle-ci et raccordée électriquement à l'électrode externe.

4. Ensemble de puce en céramique selon la revendication 1, dans lequel la base en céramique est l'un d'une thermistance, une substance magnétique et un piézoélectrique.

5. Ensemble de puce en céramique selon la revendication 1, dans lequel le centre de la section du fil conducteur est situé sur une ligne étendue depuis le centre de l'épaisseur de la base en céramique afin de permettre aux parties supérieure et inférieure de la puce en céramique d'avoir la même forme.

6. Ensemble de puce en céramique selon la revendication 1, dans lequel la base en céramique est formée pour avoir une fine épaisseur sur un substrat d'alumine isolant.

7. Ensemble de puce en céramique selon la revendication 1, dans lequel l'adhésif isolant est l'un d'un adhésif à fusion thermoplastique et d'un adhésif thermodurcissable.

8. Ensemble de puce en céramique selon la revendication 1, dans lequel l'adhésion par l'adhésif électriquement conducteur est obtenue par l'un d'un brasage à l'aide d'une crème de brasage, une adhérence à l'aide d'un adhésif polymère électriquement conducteur, et un soudage par point.

9. Ensemble de puce en céramique selon la revendication 1, dans lequel le film isolant est l'un d'un film en polytéréphtalate d'éthylène (PET), polynaphtalate d'éthylène (PEN), polyimide (PI), et polytétrafluoroéthylène (PTFE) ayant une épaisseur d'environ 0,015 mm à environ 0,07 mm.

10. Ensemble de puce en céramique selon la revendication 1, dans lequel le film isolant est l'un d'une résine en polymère thermodurcissable ou un verre.

11. Ensemble de puce en céramique selon la revendication 1, dans lequel ladite extrémité du fil conducteur est plus protubérante que la base en céramique.

12. Ensemble de puce en céramique selon la revendication 1, dans lequel les fils conducteurs en métal cylindriques comprennent des portions de ceux-ci formées dans une forme en coupe différente.
